# EUROPÄISCHE PATENTSCHRIFT

(11) **EP 1 751 806 B1**
(45) Veröffentlichungstag und Bekanntmachung des Hinweises auf die Patenterteilung: **11.09.2019**
(21) Anmeldenummer: 05748711.8
(22) Anmeldetag: 12.05.2005
(51) Int. Cl.: H01L 33/00

(54) **OPTOELEKTRONISCHES HALBLEITERBAUELEMENT UND GEHÄUSE-GRUNDKÖRPER FÜR EIN DERARTIGES BAUELEMENT**
OPTOELECTRONIC SEMICONDUCTOR COMPONENT AND HOUSING BASE FOR SUCH A COMPONENT
COMPOSANT OPTOELECTRONIQUE A SEMI-CONDUCTEUR ET CORPS DE BASE DE BOITIER POUR UN TEL COMPOSANT

(30) Priorität: 31.05.2004 DE 102004026858; 20.08.2004 DE 102004040468
(43) Veröffentlichungstag der Anmeldung: 14.02.2007
(73) Patentinhaber: OSRAM Opto Semiconductors GmbH, 93055 Regensburg (DE)
(72) Erfinder: ARNDT, Karlheinz, 93077 Bad Abbach (DE)
(74) Vertreter: Epping - Hermann - Fischer
(86) Internationale Anmeldenummer: PCT/DE2005/000877
(87) Internationale Veröffentlichungsnummer: WO 2005/117071

(56) Entgegenhaltungen:
- EP-A- 1 249 873
- WO-A-2004/068594
- DE-A1- 3 719 338
- US-A1- 2002 004 251
- US-A1- 2003 020 077
- US-A1- 2003 080 341
- US-A1- 2004 079 957
- PATENT ABSTRACTS OF JAPAN Bd. 1998, Nr. 12, 31. Oktober 1998 (1998-10-31) & JP 10 190066 A (NICHIA CHEM IND LTD), 21. Juli 1998 (1998-07-21)

## Beschreibung

Die Erfindung bezieht sich auf ein optoelektronisches Halbleiterbauelement, insbesondere auf ein elektromagnetische Strahlung aussendendes Halbleiterbauelement gemäß dem Oberbegriff des Patentanspruches 1 und auf einen Gehäuse-Grundkörper gemäß dem Oberbegriff des Patentanspruches 18.

Die Erfindung ist durch den Patentanspruch 1 und den Patentanspruch 18 definiert.

Sie bezieht sich insbesondere auf ein oberflächenmontierbares optoelektronisches Bauelement, insbesondere auf Leiterrahmen(Leadframe)-Basis, bei dem der Halbleiterchip in einer Ausnehmung eines Gehäuse-Grundkörpers angeordnet und dort befestigt ist. Der Gehäuse-Grundkörper ist vorzugsweise vorgefertigt, bevor der Halbleiterchip in die Ausnehmung montiert wird.

Solche Halbleiter-Bauelemente sind beispielsweise aus Siemens Components 29 (1991) Heft 4, Seiten 147 bis 149 bekannt. Herkömmlich werden als Umhüllungsmasse beispielsweise auf Epoxidharz basierende Vergußmaterialien verwendet. Derartige Vergußmaterialien sind aber oftmals anfällig gegenüber UV-Strahlung. Sie vergilben unter Einfluss von UV-Strahlung vergleichsweise schnell und reduzieren demzufolge die Lichtausbeute aus dem Bauelement.

Auch die Druckschrift DE 37 19 338 A1 offenbart ein optoelektronisches Halbleiterbauelement mit einem Gehäuse und einer Ausnehmung, in der eine Umhüllungsmasse angeordnet ist. Die Druckschrift EP 1 249 873 A2 offenbart eine Umhüllungsmamasse aus Silikonharz. Die Druckschrift US 2004/079957 A1 offenbart ein Halbleiterbauelement mit einem Gehäuse-Grundkörper aus Kunststoff.

Um die UV-Beständigkeit von strahlungsemittierenden optoelektronischen Halbleiterbauelementen zu verbessern ist die Verwendung von Umhüllungsmassen auf Basis von Silikonharz oder aus Silikonharz vorgeschlagen. Derartige Umhüllungsmassen vergilben unter Einfluss von kurzwelliger Strahlung nicht oder hinreichend langsam.

Solche Umhüllungsmassen bringen aber die Schwierigkeit mit sich, dass sie mit den herkömmlich verwendeten Materialien für den Gehäuse-Grundkörper (beispielsweise ein Thermoplastmaterial auf Basis von Polyphtalamid) insbesondere bei UV-Exposition für eine Reihe von Anwendungen keine hinreichend alterungsstabile Bindung eingehen, wie es beispielsweise Epoxidharz tut. Deshalb besteht bei der Verwendung einer solchen Umhüllungsmasse in herkömmlichen Gehäusebauformen, wie sie beispielsweise in Siemens Components 29 (1991) Heft 4, Seiten 147 bis 149 beschrieben sind, eine erhöhte Gefahr, dass zwischen Gehäuse-Grundkörper und Umhüllungsmasse Delamination auftritt, die am oberen Rand der Ausnehmung startet und sich in die Ausnehmung hinein fortpflanzt. Zudem kann es im schlimmsten Fall zur völligen Ablösung der Chipumhüllung aus dem Gehäuse-Grundkörper kommen.

Der vorliegenden Erfindung liegt die Aufgabe zugrunde, ein Halbleiterbauelement bzw. einen Gehäuse-Grundkörper der eingangs genannten Art, insbesondere ein oberflächenmontierbares Halbleiterbauelement bzw. einen oberflächemontierbaren Gehäuse-Grundkörper der eingangs genannten Art bereitzustellen, bei dem die Gefahr einer Delamination, insbesondere einer vollständigen Delamination zwischen Umhüllungsmasse und Gehäuse-Grundkörper verringert ist. Es soll insbesondere ein Gehäuse-Grundkörper bereitgestellt werden, der für stark miniaturisierte optoelektronische Gehäuse-Bauformen, insbesondere für stark miniaturisierte Leuchtdioden- und Photodioden-Bauformen, geeignet ist.

Diese Aufgabe wird durch ein Halbleiterbauelement mit den Merkmalen des Patenanspruches 1 beziehungsweise durch einen Gehäuse-Grundkörper mit den Merkmalen des Patentanspruches 18 gelöst.

Vorteilhafte Ausführungsformen und Weiterbildungen des Halbleiterbauelements bzw. des Gehäuse-Grundkörpers sind Gegenstand der abhängigen Ansprüche.

Im Folgenden werden Teile der Beschreibung und Zeichnungen, die sich auf Ausführungsformen oder Ausführungsbeispiele beziehen, die nicht von den Ansprüchen abgedeckt sind, nicht als Ausführungsformen oder Ausführungsbeispiele der Erfindung präsentiert, sondern als Beispiele, die zum Verständnis der Erfindung nützlich sind.

Vorliegend ist unter der Vorderseite des Halbleiterbauelements bzw. des Gehäusegrundkörpers immer diejenige äußere Oberfläche zu verstehen, die in Draufsicht auf das Halbleiterbauelement aus dessen Abstrahlrichtung zu sehen ist, von der aus folglich die Ausnehmung in den Gehäuse-Grundkörper eindringt und durch die demzufolge vom Halbleiterchip erzeugte elektromagnetische Strahlung emittiert wird.

Bei einem Halbleiterbauelement gemäß der Erfindung ist eine die Ausnehmung begrenzende Wand derart gestaltet, dass an ihr in Draufsicht auf die Vorderseite des Halbleiterbauelements
i) um den Halbleiterchip herum angeordnet mehrere abgeschatteten Teilflächen ausgebildet sind oder
ii) mindestens eine den Halbleiterchip zumindest teilweise, vorzugsweise vollständig umlaufende abgeschattete Teilfläche ausgebildet ist.

"Abgeschattet" bedeutet vorliegend insbesondere, dass die betreffende(n) Teilfläche(n) von im Wesentlichen jedem Punkt eines Strahlung emittierenden Bereiches des Strahlung aussendenden Halbleiterchips gesehen im Schatten liegt (liegen) und die zumindest teilweise von Umhüllungsmasse bedeckt ist (sind) und von der (denen) aus sich die Umhüllungsmasse zum Halbleiterchip hin erstreckt und diesen überdeckt.

Bei einem besonders bevorzugten Halbleiterbauelement beziehungsweise einem besonders bevorzugten Gehäuse-Grundkörper gemäß der Erfindung ist eine die Ausnehmung begrenzende Wand derart gestaltet, dass an ihr in Draufsicht auf die Vorderseite des Halbleiterbauelements eine den Halbleiterchip vollständig ringartig umlaufende abgeschattete Teilfläche ausgebildet ist, die insbesondere von im Wesentlichen jedem Punkt eines Strahlung emittierenden Bereiches des Strahlung aussendenden Halbleiterchips gesehen im Schatten liegt und die vollständig um den Halbleiterchip herum zumindest teilweise von Umhüllungsmasse bedeckt ist und von der aus sich die Umhüllungsmasse zum Halbleiterchip hin erstreckt und diesen überdeckt.

Die abgeschattete Teilfläche verläuft besonders bevorzugt von der Bauelement-Vorderseite in Richtung Halbleiterchip durchweg trichterartig, wobei sie die Ausnehmung in Richtung zum Halbleiterchip hin verjüngt.

Die abgeschattete Teilfläche ist besonders bevorzugt am oberen Rand der Wand angeordnet, derart, dass die Dreiphasen-Grenzlinie von Luft/Umhüllungsmasse/Gehäuse-Grundkörper vollständig auf der abgeschatteten Teilfläche verläuft und damit nicht oder nur in hinreichend verringertem Maße (beispielsweise aufgrund von Reflexionen an der Vorderseite der Umhüllung) mit einer vom Halbleiterchip herrührenden an dieser Stelle unerwünschten Strahlung beaufschlagt wird.

Bevorzugt ist die mindestens eine abgeschattete Teilfläche am Rand der Ausnehmung zur Vorderseite des Gehäuse-Grundkörpers hin ausgebildet, insbesondere an der vorderseitigen Stirnseite der Wand, oder stellt selbst die vorderseitige Stirnseite der Wand dar. Dies ermöglicht vorteilhafterweise eine äußerst platzsparende Realisierung der abgeschatteten Teilfläche und damit des gesamten Bauelements, ohne dass die (reflektierende) Ausnehmung im Vergleich zu herkömmlichen Bauelementen ohne UV-Problematik und Expoxidumhüllung verkleinert werden muß.
Die mindestens eine abgeschattete Teilfläche kann vorteilhafterweise technisch besonders einfach mittels mindestens einer, ggf. aus Platzgründen vorzugsweise mittels einer einzigen Fase am vorderseitigen Rand der Wand ausgebildet sein, die zur Ausnehmung hin geneigt ist. Der vorderseitige Rand der Ausnehmung ist hier somit trichterartig zum Halbleiterchip hin ausgebildet. Bei einer vorteilhaften Ausführungsform ist die Stirnseite der Wand zumindest teilweise über ihre gesamte Breite trichterartig ausgebildet und damit zumindest zum Teil als Bestandteil der Ausnehmung zu betrachten.

Eine durchweg trichterartig ausgebildete abgeschattete Teilfläche, wie sie durch eine erfindungsgemäße Ausgestaltung des Gehäuse-Grundkörpers möglich ist, bringt die besonderen Vorteile mit sich, dass sie gut mit der Umhüllungsmasse füllbar ist und dass ein als Reflektor dienender Bereich der Ausnehmung gegenüber herkömmlichen von der Bauform her gleichartigen Bauelementen aufgrund der erfindungsgemäßen Geometrie der Ausnehmung nicht verkleinert ist.

Bei einer anderen vorteilhaften Ausgestaltung ist die abgeschattete Teilfläche mittels mindestens einer, ggf. aus Platzgründen vorzugsweise mittels einer einzigen im Querschnitt konkaven Abschrägung der Wand an deren vorderseitigem Rand ausgebildet. Mittels dieser Ausgestaltung kann auch bei einem Gehäuse-Grundkörper mit einer größeren Ausnehmung und flach auf die Wand treffender Strahlung eine abgeschattete Teilfläche erzielt werden.

Ein Gehäuse-Grundkörper gemäß der Erfindung wird besonders bevorzugt bei Halbleiterbauelementen eingesetzt, die mit einem Halbleiterchip versehen sind, der zumindest teilweise UV-Strahlung emittiert, wie beispielsweise ein blaues Licht oder UV-Strahlung emittierender, auf Nitrid-Verbindungshalbleitermaterial basierender Leuchtdiodenchip, wie er beispielsweise in der WO 01/39282 A2 beschrieben ist und von daher an dieser Stelle nicht näher erläutert wird.

"Auf Nitrid-Verbindungshalbleitern basierend" bedeutet im vorliegenden Zusammenhang, dass die strahlungserzeugende Epitaxie-Schichtenfolge oder zumindest ein Teil davon ein Nitrid-III/V-Verbindungshalbleitermaterial, vorzugsweise AlₙGa-ₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften eines des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die Umhüllungsmasse basiert vorzugsweise auf Silikonmaterial und ist insbesondere ein Silikonharz. Eine gelartige Konsistenz der Umhüllungsmasse kann die Verringerung der Delaminationsgefahr weiterhin unterstützen.

Hinsichtlich einer weiteren Verringerung der Delaminationsgefahr sind erfindungsgemäß Verankerungselemente vorgesehen, die auf der (den) abgeschatteten Teilfläche(n) der Innenseite ausgebildet sind und die ausgehend von der abgeschatteten Teilfläche der Ausnehmung in die Umhüllungsmasse ragen. Diese Verankerungselmente sind bevorzugt gleichmäßig auf der abgeschatteten Teilfläche verteilt, das heißt mit im Wesentlichen gleichen Abständen untereinander, angeordnet.

Als Verankerungselemente eignen sich von der abgeschatteten Teilfläche herausragende Verankerungsnasen, -noppen oder - rippen. Die Verankerungselmente sind besonders bevorzugt vollständig von der Umhüllungsmasse überdeckt, das heißt überspannt. Dazu ist der Füllstand der Umhüllungsmasse innerhalb der Ausnehmung insbesondere so hoch, dass die Umhüllungsmasse die Verankerungselemente vollständig abdeckt. Dies wirkt wiederum der Delamination entgegen und erleichtert auch die Weiterverarbeitung der Bauelement mittels herkömmlicher Pick-and-Place-Vorrichtungen.

Derartige Verankerungselemente können vorteilhafterweise weiterhin dazu beitragen, dass sich ein in flüssigem Zustand in die Ausnehmung eingefülltes Umhüllungsmaterial, wie Silikonharz, aufgrund der durch die Kapillarität des Umhüllungsmaterials hervorgerufenen Kräfte an den Verankerungselementen entlang hochzieht, wodurch die Benetzung der abgeschattete(n) Teilfläche(n) und des oberen Randes der Ausnehmung unterstützt wird.

Die oben genannte Aufgabe wird demnach insbesondere durch ein Halbleiterbauelement gelöst, bei dem die Umhüllungsmasse auf mindestens einer abgeschatteten Teilfläche am äußeren Rand der Ausnehmung des Gehäuse-Grundkörpers, die von der vom Halbleiterchip ausgesandten Strahlung zumindest zu einem wesentlichen Teil abgeschattet ist, einen Dichtstreifen ausbildet, der folglich gegenüber der Strahlung des Chips weitestgehend abgeschattet ist. Besonders bevorzugt bildet die Umhüllungsmasse auf einer ringartig vollständig um den Halbleiterchip umlaufenden abgeschatteten Teilfläche einen durchgängigen abgeschatteten Dichtring aus.

Vorzugsweise ist der übrige Teil der Ausnehmung als Reflektor für die vom Halbleiterchip ausgesandte Strahlung ausgebildet.

Bei einer besonders bevorzugten Ausführungsform ist der Gehäuse-Grundkörper an einen metallischen Leiterrahmen (Leadframe) aus einer Kunststoff-Formmasse angeformt, insbesondere mittels eines Spritz- und/oder Press-Verfahrens.

In die Umhüllungsmasse kann Leuchtstoffmaterial eingemischt sein, das einen Teil der vom Halbleiterchip emittierten Strahlung absorbiert und Strahlung mit im Vergleich zur absorbierten Strahlung geänderter Wellenlänge emittiert. Ebenso kann der Halbleiterchip mit einer Leuchtstoffmaterial enthaltenden Mantelschicht versehen sein. Dadurch können auf einfache Weise Leuchtdiodenbauelemente hergestellt werden, die in der Lage sind, mischfarbiges Licht oder farbangepaßtes Licht auszusenden. Geeignete Leuchtstoffmaterialien sind beispielsweise in der WO 97/50132 und in der WO_98/12757 A1 beschrieben, deren Offenbarungsgehalt hiermit insofern durch Rückbezug aufgenommen wird.

Bevorzugt ist die äußerste Kante des oberen Randes der Ausnehmung bzw. der abgeschatteten Teilfläche weitestgehend glatt, das heißt ohne Riefen, Vertiefungen, Lunker oder ähnlichem. Dies mindert vorteilhafterweise die Gefahr des Überlaufens der Umhüllungsmasse beim Füllen der Ausnehmung. Die Verankerungselemente gehen vorzugsweise ggf. nicht bis zum äußeren Rand der Ausnehmung, um eine glatte Kante sicherzustellen.

Das vorangehend zu erfindungsgemäßen Bauelementen gesagte gilt analog für erfindungsgemäße Gehäuse-Grundkörper.

Ein Bauelement-Gehäuse (Gehäusegrundkörper + Umhüllungsmasse) gemäß der Erfindung läßt sich nicht nur mit Vorteil bei strahlungsemittierenden Bauelementen, deren Halbleiterchip insbesondere zumindest teilweise UV-Strahlung emittiert, einsetzen, sondern läßt sich auch mit Vorteil (z. B. erhöhte Hitzebeständigkeit) bei strahlungsdetektierenden Bauelementen wie Photodioden- und Phototransistor-Bauelemente einsetzen.

Ein gemäß der vorliegenden Erfindung ausgebildetes Bauelement-Gehäuse (Gehäusegrundkörper + Umhüllungsmasse) ermöglicht es, Bauformen mit vergleichsweise sehr geringen Abmessungen zu realisieren, weil die Ausnehmung erst am vorderseitigen Ende des Gehäuse-Grundkörpers, das heißt unmittelbar am Übergang von der Innenwand der Ausnehmung zur äußeren Vorderseite des Gehäuse-Grundkörpers die im Schatten liegende(n) Teilfläche(n) aufweist.

Ein weiterer besonderer Vorteil besteht darin, dass die "Dreiphasen"-Grenzlinie Gehäuse-Grundkörper/Umhüllungsmasse/Luft (oder andere umgebende Atmosphäre) keiner oder nur einer deutlich verringerten Strahlung des Halbleiterchips ausgesetzt ist.

Weitere Vorteile und vorteilhafte Weiterbildungen des Bauelements bzw. des Gehäuse-Grundkörpers ergeben sich aus den im Folgenden unter Bezugnahme auf die Figuren 1 bis 6 beschriebenen Ausführungsbeispielen. Es zeigen:
- Figur 1,: eine schematische Darstellung einer Schnittansicht durch ein erstes, zum Verständnis der Erfindung nützliches Beispiel eines Bauelements,
- Figur 2,: eine schematische Darstellung einer Schnittansicht durch ein zweites, zum Verständnis der Erfindung nützliches Beispiel eines Bauelements,
- Figur 3,: eine schematische Darstellung einer Schnittansicht durch ein Ausführungsbeispiel eines erfindungsgemäßen Bauelements,
- Figur 4,: eine schematische Darstellung einer weiteren Schnittansicht durch das zweite, zum Verständnis der Erfindung nützliche Beispiel
- Figur 5,: eine schematische Darstellung einer perspektivischen Draufsicht auf den Gehäuse-Grundkörper des ersten, zum Verständnis der Erfindung nützlichen Beispieles,
- Figur 6,: eine schematische Darstellung einer perspektivischen Draufsicht auf den Gehäuse-Grundkörper des Ausführungsbeispieles.

In den Figuren sind gleiche oder gleichwirkende Bestandteile der Ausführungsbeispiele jeweils gleich bezeichnet und mit den gleichen Bezugszeichen versehen. Die Figuren sind grundsätzlich nicht als maßstabsgerechte Darstellungen von realen Vorrichtungen gemäß der Erfindung anzusehen. Vielmehr können einzelne Bestandteile der Ausführungsbeispiele in den Figuren zum besseren Verständnis übertrieben groß oder in nicht der Realität entsprechenden Größenverhältnissen untereinander dargestellt sein.

Bei den in den Figuren schematisch dargestellten Bauelementen bzw. Gehäuse-Grundkörpern handelt es sich jeweils um ein oberflächenmontierbares sogenanntes Sidelooker-Leuchtdiodenbauelement bzw. einen oberflächenmontierbaren Gehäuse-Grundkörper 3 für ein solches Leuchtdiodenbauelement mit einem gegebenenfalls unter anderem UV-Strahlung emittierenden Leuchtdiodenchip 1, beispielsweise einen auf InGaN basierenden sichtbares blaues Licht emittierenden Leuchtdiodenchip, der gewollt oder nicht gewollt zusätzlich UV-Strahlung emittiert. Ein solcher Leuchtdiodenchip ist beispielsweise in der WO 01/39282 A2 beschrieben und wird von daher an dieser Stelle nicht näher erläutert.

Die in diesem Zusammenhang erläuterten Bauelement-Gehäuse und Gehäuse-Grundkörper eignen sich grundsätzlich auch für die Anwendung bei andersartigen Leuchtdiodenchips, ebenso wie für IR-emittierende Bauelemente, die insbesondere für Hochtemperaturanwendungen vorgesehen sind.

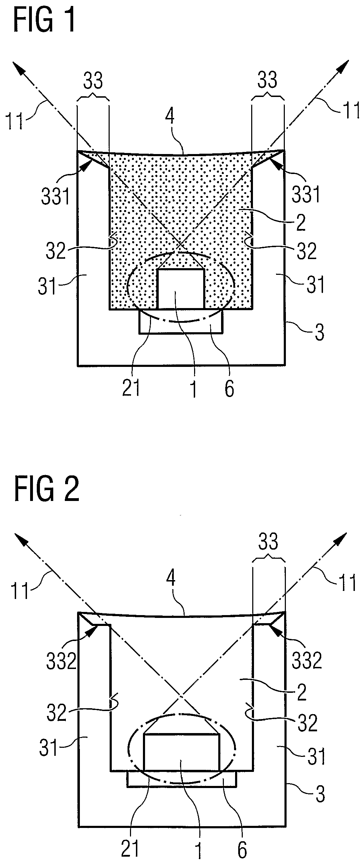

Der Leuchtdiodenchip 1 ist in einem Chipbereich (angedeutet durch die in den Figuren 1 bis 4 gestrichelt umrandeten Bereiche 21) des Gehäuse-Grundkörpers 3 auf einem elektrischen Chipanschlußteil eines metallischen Leiterrahmens (Leadframe) 6 montiert und über einen Bonddraht 5 mit einem Drahtanschlußbereich eines vom Chipanschlußteil 62 elektrisch getrennten elektrischen Drahtanschlußteiles 61 des Leiterrahmens 6 verbunden.

Andersartig kontaktierte Leuchtdiodenchips, wie beispielsweise Flip-Chip-montierte Leuchtdiodenchips, bei denen Anoden- und Katodenkontakt auf einer Seite des Chips angeordnet und zum Leiterrahmen hin gewandt sind, sind vorliegend ebenso einsetzbar. Lediglich die Montagetechnik ist hierbei anzupassen.

Am Leiterrahmen 6 befindet sich ein beispielsweise aus Thermoplast-Kunststoff (z. B. eine mit Titanoxid oder Siliziumoxid und/oder Glasfasern gefüllte auf Polyphtalamid basierte Pressmasse) spritzgegossener oder spritzgepresster Gehäuse-Grundkörper 3 mit einer Ausnehmung 2. In der Ausnehmung 2 befindet sich der Leuchtdiodenchip 1, der beispielsweise mittels eines Leitklebers auf dem Chipanschlußteil 62 elektrisch leitend befestigt ist.

Die Ausnehmung 2 ist seitlich von einer den Halbleiterchip 1 umlaufenden Wand 31 begrenzt und zumindest teilweise mit einer Umhüllungsmasse 4 auf Basis von Silikonharz gefüllt, die den Halbleiterchip 1 überdeckt und die für eine vom Halbleiterchip 1 ausgesandte elektromagnetische Strahlung gut durchlässig ist.

Die Umhüllungsmasse 4 umfaßtbeispielsweise ein strahlungsdurchlässiges, zum Beispiel klares, gelartiges Vergußmaterial auf Silikonbasis, dem ein Leuchtstoffpulver 7, beispielsweise ein auf YAG:Ce, auf TbAG:Ce oder auf TbYAG:Ce basierendes Leuchtstoffpulver beigemischt ist. Solche Leuchtstoffe sind beispielsweise aus der WO 98/12757 und aus der WO 01/08452 bekannt, deren Offenbarungsgehalt insofern hiermit durch Rückbezug aufgenommen wird.

Bei Bauelementen, die ausschließlich originäre Strahlung des Leuchtdiodenchips 1 aussenden sollen, kann die Umhüllungsmasse 4 ein klares, gelartiges Vergußmaterial auf Silikonbasis sein. Alternativ kann dieses mit Diffusorpartikeln versehen und von diesem eingetrübt sein.

Eine die Ausnehmung 2 begrenzende Innenseite 32 weist am vorderseitigen Ende der Wand 31 eine zum Innern der Ausnehmung 2 hin nach unten, das heißt zum Halbleiterchip 1 hin geneigte und die Ausnehmung vollständig umlaufende Fase 331 auf. Diese Fase 331 erzeugt eine in Draufsicht auf die Vorderseite des Halbleiterbauelements gesehen den Halbleiterchip 1 vollständig ringartig umlaufende abgeschattete Teilfläche 33, die von allen vorderseitigen Punkten des Halbleiterchips 1 aus gesehen vollständig im Schatten liegt und die vollständig umlaufend um den Halbleiterchip 1 zumindest teilweise von Umhüllungsmasse 4 bedeckt ist. Der vorderseitige Rand der Ausnehmung ist trichterartig ausgebildet. Die abgeschattete Teilfläche ist gleichzeitig die vorderseitige Stirnseite der Wand 31.

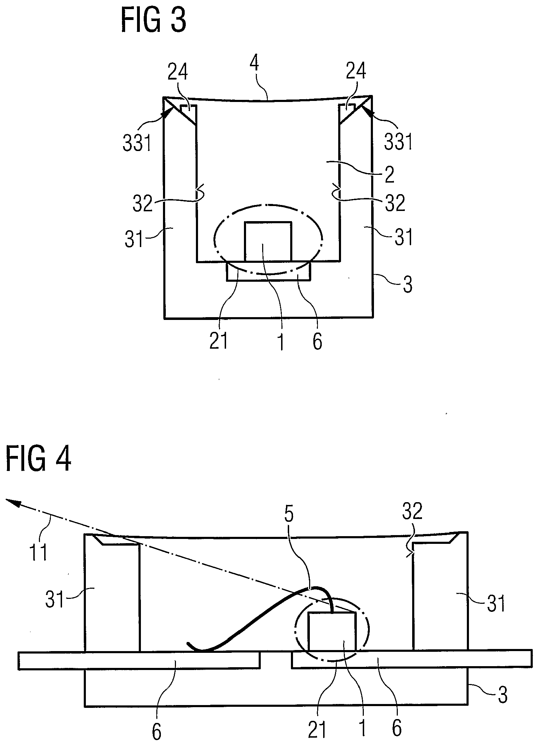

Das zweite Beispiel gemäß den Figuren 2 und 4 unterscheidet sich von dem vorangehend beschriebenen ersten Beispiel insbesondere dadurch, dass die ringartig umlaufende abgeschattete Teilfläche 33 der Innenseite 32 mittels einer im Querschnitt konkaven Abschrägung 332 der vorderseitigen Stirnseite der Wand 31 ausgebildet ist.

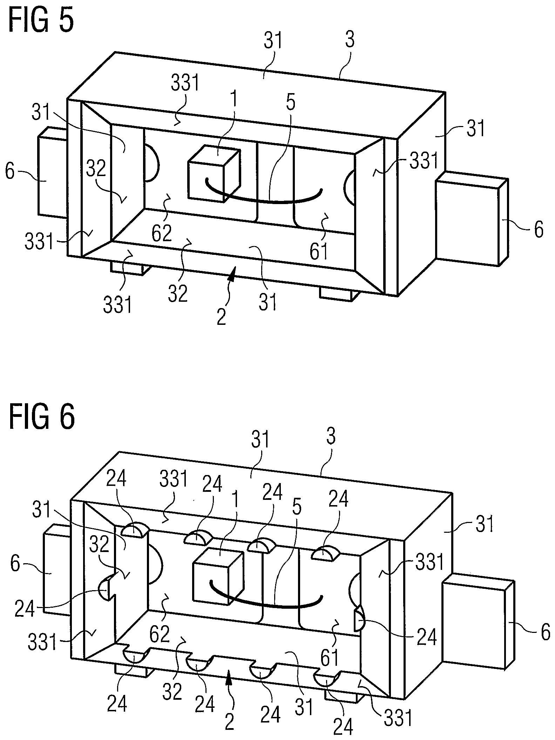

Das Ausführungsbeispiel gemäß den Figuren 3 und 6 unterscheidet sich von dem vorangehend beschriebenen ersten Ausführungsbeispiel insbesondere dadurch, dass an der ringartig umlaufenden abgeschatteten Teilfläche 33 eine Mehrzahl von Verankerungselementen 24, hier in Form von Verankerungsnoppen, gleichmäßig um die Ausnehmung 2 herum verteilt ausgebildet sind. Diese Verankerungsnoppen ragen ausgehend von der abgeschatteten Teilfläche 33 in die Umhüllungsmasse 4 hinein, durchdringen diese aber nicht, das heißt, sie sind von der Umhüllungsmasse 4 vollständig überdeckt. Gesehen vom Halbleiterchip 1 ist die Umhüllungsmasse auf der abgeschatteten Teilfläche 33 hinter den Verankerungselmenten 24 durchgehend umlaufend.

Für alle Ausführungsbeispiele sind der Gehäuse-Grundkörper 3 zusammen mit den Verankerungselementen 24 vorzugsweise einstückig ausgebildet und vorzugsweise in einem einzigen Spritzguß- oder Spritzpressvorgang gefertigt.

Den Ausführungsbeispielen entsprechende Gehäusegrundkörper und Umhüllungsmassen können auch für strahlungsempfangende Halbleiterchips, wie Photodiodenchips, eingesetzt werden. An die Stelle des Leuchtdiodenchips 1 kann dann ein Photodiodenchip treten. Ebenso eignet sich die erfindungsgemäße Bauform für den Einsatz bei Laserdiodenbauelementen, Detektorbauelementen und für Hochtemperaturanwendungen.

Die Erläuterung der erfindungsgemäßen technischen Lehre anhand der Ausführungsbeispiele ist selbstverständlich nicht als Beschränkung der Erfindung auf diese zu verstehen. Vielmehr nutzen beispielsweise sämtliche Bauelemente und Gehäuse-Grundkörper, die eine Ausnehmung zur Aufnahme eines Halbleiterchips und eine am vorderseitigen Rand der Ausnehmung umlaufende Fase oder ähnliches aufweisen, die von der Strahlung des Halbleiterchips abgeschattet ist, die erfindungsgemäße technische Lehre.

## Patentansprüche

1. Optoelektronisches Halbleiterbauelement mit mindestens einem Strahlung (11) aussendenden Halbleiterchip (1) und einem Gehäuse-Grundkörper (3), wobei
- der Halbleiterchip (1) in einer Ausnehmung (2) des Gehäuse-Grundkörpers (3) angeordnet ist,
- die Ausnehmung (2) seitlich von einer Innenseite (32) einer den Halbleiterchip (1) umlaufenden Wand (31) begrenzt ist und zumindest teilweise mit einer Umhüllungsmasse (4) gefüllt ist, die den Halbleiterchip (1) überdeckt und die für eine vom Halbleiterchip (1) ausgesandte elektromagnetische Strahlung gut durchlässig ist,
- die Innenseite (32) der Wand (31) derart ausgebildet ist, dass sie in Draufsicht auf die Vorderseite des Halbleiterbauelements gesehen mindestens eine Teilfläche (33) aufweist, die gesehen von dem Strahlung aussendenden Halbleiterchip (1) im Schatten liegt und die zumindest teilweise von Umhüllungsmasse (4) bedeckt ist und von der aus sich die Umhüllungsmasse (4) zum Halbleiterchip (1) hin erstreckt und diesen überdeckt,
- die mindestens eine Teilfläche (33) an einem Rand der Innenseite (32) zur Vorderseite des Gehäuse-Grundkörpers (3) hin ausgebildet ist, und die Innenseite (32) sich in einem Bereich zwischen einer Bodenfläche der Ausnehmung (2) und der Teilfläche (33) senkrecht zu der Bodenfläche erstreckt,
**dadurch gekennzeichnet, dass**
- an der mindestens einen Teilfläche (33) der Innenseite (32) mindestens ein Verankerungselement (24) ausgebildet ist, das in die Umhüllungsmasse (4) ragt.

2. Halbleiterbauelement nach Anspruch 1,
**dadurch gekennzeichnet, dass**
die Innenseite (32) der Wand (31) derart ausgebildet ist, dass sie in Draufsicht auf die Vorderseite des Halbleiterbauelements gesehen um den Halbleiterchip herum angeordnet mehrere Teilflächen (33) aufweist, die gesehen von dem Strahlung aussendenden Halbleiterchip (1) im Schatten liegen und die zumindest teilweise von Umhüllungsmasse (4) bedeckt sind und von denen aus sich die Umhüllungsmasse (4) zum Halbleiterchip (1) hin erstreckt und diesen überdeckt.

3. Halbleiterbauelement nach Anspruch 1,
**dadurch gekennzeichnet, dass**
die Innenseite (32) der Wand (31) derart ausgebildet ist, dass sie in Draufsicht auf die Vorderseite des Halbleiterbauelements gesehen eine den Halbleiterchip (1) vollständig ringartig umlaufende Teilfläche (33) aufweist, die gesehen von dem Strahlung aussendenden Halbleiterchip (1) im Schatten liegt und die vollständig umlaufend um den Halbleiterchip (1) zumindest teilweise von Umhüllungsmasse (4) bedeckt ist.

4. Halbleiterbauelement nach einem der Ansprüche 1 bis 3,
**dadurch gekennzeichnet, dass**
eine Dreiphasen-Grenzlinie von Luft/Umhüllungsmasse/Gehäuse-Grundkörper vollständig auf der Teilfläche (33) verläuft.

5. Halbleiterbauelement nach einem der Ansprüche 1 bis 3,
**dadurch gekennzeichnet, dass**
die mindestens eine Teilfläche (33) der Innenseite (32) die Vorderseite des Gehäuse-Grundkörpers (3) ist.

6. Halbleiterbauelement nach einem der Ansprüche 1 bis 5,
**dadurch gekennzeichnet, dass** die mindestens eine Teilfläche (33) der Innenseite (32) mittels mindestens einer Fase (331) am vorderseitigen Rand der Wand (31) ausgebildet ist.

7. Halbleiterbauelement nach einem der Ansprüche 1 bis 5,
**dadurch gekennzeichnet, dass**
die mindestens eine Teilfläche (33) der Innenseite (32) mittels mindestens einer im Querschnitt konkaven Abschrägung (332) der Wand (31) an deren vorderseitigem Rand ausgebildet ist.

8. Halbleiterbauelement nach mindestens einem der vorangehenden Ansprüche,
**dadurch gekennzeichnet, dass**
der Halbleiterchip (1) ein Material aufweist, das geeignet ist, zumindest teilweise UV-Strahlung zu emittieren.

9. Halbleiterbauelement nach mindestens einem der vorangehenden Ansprüche,
**dadurch gekennzeichnet, dass**
die Umhüllungsmasse (4) ein auf Silikon basierendes Material, insbesondere Silikonharz enthält.

10. Halbleiterbauelement nach mindestens einem der vorangehenden Ansprüche,
**dadurch gekennzeichnet, dass**
die Umhüllungsmasse (4) eine gelartige Konsistenz aufweist.

11. Halbleiterbauelement nach mindestens einem der vorhergehenden Ansprüche,
**dadurch gekennzeichnet, dass**
an der mindestens einen Teilfläche (33) der Innenseite (32) verteilt, insbesondere gleichmäßig um die Ausnehmung (2) verteilt, mehrere Verankerungselemente (24) angeordnet sind, die ausgehend von der Teilfläche (33) in die Umhüllungsmasse (4) ragen.

12. Halbleiterbauelement nach mindestens einem der vorhergehenden Ansprüche,
**dadurch gekennzeichnet, dass**
das (die) Verankerungselement(e) als aus der mindestens einen Teilfläche (33) der Innenseite (32) herausragende Verankerungsnase(n), -noppe(n) oder -rippe(n) ausgebildet ist (sind) und die Umhüllungsmasse (4) das (die)
Verankerungselement(e) überspannt.

13. Halbleiterbauelement nach mindestens einem der vorangehenden Ansprüche,
**dadurch gekennzeichnet, dass**
die Umhüllungsmasse (4) auf der mindestens einen Teilfläche (33) der Innenseite (32) einen durchgängigen Dichtring um die Ausnehmung (2) ausbildet.

14. Halbleiterbauelement nach mindestens einem der vorangehenden Ansprüche,
**dadurch gekennzeichnet, dass**
die Ausnehmung (2) als Reflektor für die vom Halbleiterchip ausgesandte Strahlung ausgebildet ist.

15. Halbleiterbauelement nach mindestens einem der vorangehenden Ansprüche,
**dadurch gekennzeichnet, dass**
der Gehäuse-Grundkörper (3) an einem metallischen Leiterrahmen (6) einstückig aus einer Kunststoff-Formmasse vorgefertigt ist.

16. Halbleiterbauelement nach mindestens einem der vorangehenden Ansprüche,
**dadurch gekennzeichnet, dass**
die Umhüllungsmasse (4) mindestens ein Leuchtstoffmaterial enthält, das geeignet ist, einen Teil der vom Halbleiterchip (1) emittierten Strahlung zu absorbieren und Strahlung mit im Vergleich zur absorbierten Strahlung geänderter Wellenlänge zu emittieren.

17. Halbleiterbauelement nach mindestens einem der vorangehenden Ansprüche,
**dadurch gekennzeichnet, dass**
der Halbleiterchip (1) mindestens ein Leuchtstoffmaterial aufweist, das geeignet ist, einen Teil der vom Halbleiterchip (1) emittierten Strahlung zu absorbieren und Strahlung mit im Vergleich zur absorbierten Strahlung geänderter Wellenlänge zu emittieren.

18. Gehäuse-Grundkörper für mindestens einen Halbleiterchip (1), insbesondere für ein Strahlung aussendendes Halbleiterbauelement mit mindestens einem Strahlung (11) aussendenden Halbleiterchip (1), der eine Ausnehmung (2) zur Aufnahme eines Halbleiterchips (1) aufweist, in der sich ein Chipbereich (21) befindet und die seitlich von einer Innenseite (32) einer den Chipbereich (21) umlaufenden Wand (31) begrenzt ist,wobei
- die Innenseite (32) der Wand (31) derart ausgebildet ist, dass sie in Draufsicht auf eine Vorderseite des Gehäuse-Grundkörpers gesehen mindestens eine Teilfläche (33) aufweist, die gesehen von dem Chipbereich (21) im Schatten liegt, und dass sie mit einer zur zumindest teilweisen Umhüllung des Halbleiterchips (1) vorgesehenen Umhüllungsmasse derart füllbar ist, dass sich diese ausgehend von der Teilfläche (33) zum Halbleiterchip (1) hin erstreckt und diesen überdeckt, wobei
- die mindestens eine Teilfläche (33) an einem Rand der Innenseite (32) zur Vorderseite des Gehäuse-Grundkörpers (3) hin ausgebildet ist, und die Innenseite (32) sich in einem Bereich zwischen einer Bodenfläche der Ausnehmung (2) und der Teilfläche (33) senkrecht zu der Bodenfläche erstreckt **dadurch gekennzeichnet, dass**
an der mindestens einen Teilfläche (33) der Innenseite (32) mindestens ein von der Teilfläche (33) hervorstehendes Verankerungselement (24) für die Umhüllungsmasse (4) ausgebildet ist.

19. Gehäuse-Grundkörper nach Anspruch 18,
**dadurch gekennzeichnet,**
**dass** die Innenseite (32) der Wand (31) derart ausgebildet ist, dass sie in Draufsicht auf eine Vorderseite des Gehäuse-Grundkörpers gesehen um den Chipbereich (21) herum angeordnet mehrere Teilflächen (33) aufweist, die gesehen von dem Chipbereich (21) im Schatten liegen, und dass sie mit einer zur zumindest teilweisen Umhüllung des Halbleiterchips (1) vorgesehenen Umhüllungsmasse derart füllbar ist, dass sich diese ausgehend von den Teilflächen (33) zum Halbleiterchip (1) hin erstreckt und diesen überdeckt.

20. Gehäuse-Grundkörper nach Anspruch 18,
**dadurch gekennzeichnet,**
**dass** die Innenseite (32) der Wand (31) derart ausgebildet ist, dass sie in Draufsicht auf die Vorderseite des Gehäuse-Grundkörpers gesehen eine den Chipbereich (21) vollständig ringartig umlaufende Teilfläche (33) aufweist, die gesehen von dem Chipbereich (21) im Schatten liegt, und dass sie mit einer zur zumindest teilweisen Umhüllung des Halbleiterchips (1) vorgesehenen Umhüllungsmasse derart füllbar ist, dass sich diese ausgehend von der Teilfläche (33) zum Halbleiterchip (1) hin erstreckt und diesen überdeckt.

21. Gehäuse-Grundkörper nach einem der Anspruch 18 bis 20,
**dadurch gekennzeichnet, dass**
die Teilfläche (33) von der Vorderseite des Gehäuse-Grundkörpers in Richtung Chipbereich (21) durchweg trichterartig verläuft.

22. Gehäuse-Grundkörper nach einem der Anspruch 18 bis 20,
**dadurch gekennzeichnet, dass**
die mindestens eine Teilfläche (33) der Innenseite (32) die Vorderseite des Gehäuse-Grundkörpers (3) ist.

23. Gehäuse-Grundkörper nach einem der Anspruch 18 bis 22,
**dadurch gekennzeichnet, dass**
die mindestens eine Teilfläche (33) der Innenseite (32) mittels mindestens einer Fase (331) am vorderseitigen Ende der Wand (31) ausgebildet ist.

24. Gehäuse-Grundkörper nach Anspruch 18 bis 22,
**dadurch gekennzeichnet, dass**
die mindestens eine Teilfläche (33) der Innenseite (32) mittels mindestens einer im Querschnitt konkaven Abschrägung (332) der Wand (31) an deren vorderseitigem Ende ausgebildet ist.

25. Gehäuse-Grundkörper nach Anspruch 18 bis 24,
**dadurch gekennzeichnet, dass**
an der mindestens einen Teilfläche (33) der Innenseite (32) verteilt, insbesondere gleichmäßig um die Ausnehmung (2) verteilt, mehrere Verankerungselemente (24) für die Umhüllungsmasse (4) angeordnet sind.

26. Gehäuse-Grundkörper nach Anspruch 25,
**dadurch gekennzeichnet, dass**
die Ausnehmung (2) derart ausgebildet ist, dass die Umhüllungsmasse (4) auf der mindestens einen Teilfläche (33) der Innenseite (32) von innerhalb gesehen außerhalb der Verankerungselemente (24) einen durchgängigen Dichtring um die Ausnehmung (2) ausbilden kann.

27. Gehäuse-Grundkörper nach mindestens einem der Ansprüche 18 bis 26,
**dadurch gekennzeichnet, dass**
die Ausnehmung (2) als Reflektor ausgebildet ist.

28. Gehäuse-Grundkörper nach mindestens einem der Ansprüche 18 bis 27,
**dadurch gekennzeichnet, dass**
der Gehäuse-Grundkörper (3) an einem metallischen Leiterrahmen (6) vorgefertigt ist.

## Claims

1. Optoelectronic semiconductor component having at least one semiconductor chip (1) which emits radiation (11) and a housing base body (3), where
- the semiconductor chip (1) is arranged in a recess (2) of the housing base body (3),
- the recess (2) is bounded laterally by an inner side (32) of a wall (31) surrounding the semiconductor chip (1) and is at least partially filled with a covering mass (4) which covers the semiconductor chip (1) and is well permeable to electromagnetic radiation emitted by the semiconductor chip (1),
- the inner side (32) of the wall (31) is formed in such a way that, seen in plan view of the front side of the semiconductor component, it has at least one partial surface (33) which, seen from the radiation-emitting semiconductor chip (1), lies in the shade and which is at least partially covered by covering mass (4) and from which the covering mass(4) extends towards the semiconductor chip (1) and covers the latter,
- the at least one partial surface (33) is formed at an edge of the inner side (32) towards the front side of the housing base body (3), and the inner side (32) extends in a region between a bottom surface of the recess (2) and the partial surface (33) perpendicular to the bottom surface, **characterized in that**
- at least one anchoring element (24), which projects into the covering mass (4), is formed on the at least one partial surface (33) of the inner side (32).

2. Semiconductor component according to claim 1,
**characterized in that**
the inner side (32) of the wall (31) is formed in such a way that, viewed in plan view of the front side of the semiconductor component, it has, arranged around the semiconductor chip, a plurality of partial surfaces (33) which, viewed from the radiation-emitting semiconductor chip (1), lie in the shade and which are at least partially covered by covering mass (4) and from which the covering mass (4) extends towards the semiconductor chip (1) and covers the latter.

3. Semiconductor component according to claim 1,
**characterized in that**
the inner side (32) of the wall (31) is formed in such a way that, seen in plan view of the front side of the semiconductor component, it has a partial surface (33) which completely surrounds the semiconductor chip (1) in the manner of a ring, is in the shade, as seen by the semiconductor chip (1) emitting radiation, and is at least partially covered by covering mass (4) completely surrounding the semiconductor chip (1).

4. Semiconductor component according to any of claims 1 to 3,
**characterized in that**
a three-phase boundary line of air/covering mass/housing base body extends completely on the partial surface (33).

5. Semiconductor component according to any of claims 1 to 3,
**characterized in that**
the at least one partial surface (33) of the inner side (32) is the front side of the housing base body (3).

6. Semiconductor component according to any of claims 1 to 5,
**characterized in that** the at least one partial surface (33) of the inner side (32) is formed on the front edge of the wall (31) by means of at least one chamfer (331).

7. Semiconductor component according to any of claims 1 to 5,
**characterized in that**
the at least one partial surface (33) of the inside (32) is formed by means of at least one bevel (332) of the wall (31) which is concave in cross-section at its front edge.

8. Semiconductor component according to at least one of the preceding claims,
**characterized in that**
said semiconductor chip (1) comprises a material capable of emitting at least partially UV radiation.

9. Semiconductor component according to at least one of the preceding claims,
**characterized in that**
the covering mass (4) comprises a silicone-based material, in particular silicone resin.

10. Semiconductor component according to at least one of the preceding claims,
**characterized in that**
the covering mass (4) has a gel-like consistency.

11. Semiconductor component according to at least one of the preceding claims,
**characterized in that**
a plurality of anchoring elements (24) are arranged on the at least one partial surface (33) of the inner side (32), in particular distributed uniformly around the recess (2), which anchoring elements (24) project from the partial surface (33) into the covering mass (4).

12. Semiconductor component according to at least one of the preceding claims,
**characterized in that**
the anchoring element(s) is (are) formed as an anchoring nose(s), nipple(s) or rib(s) projecting from the at least one partial surface (33) of the inner side (32), and the covering mass (4) spans the anchoring element(s).

13. Semiconductor component according to at least one of the preceding claims,
**characterized in that**
the covering mass (4) forms a continuous sealing ring around the recess (2) on the at least one partial surface (33) of the inner side (32).

14. Semiconductor component according to at least one of the preceding claims,
**characterized in that**
the recess (2) is formed as a reflector for the radiation emitted by the semiconductor chip.

15. Semiconductor component according to at least one of the preceding claims,
**characterized in that**
the housing base body (3) is prefabricated in one piece on a metallic lead frame (6) from a plastics moulding compound.

16. Semiconductor component according to at least one of the preceding claims,
**characterized in that**
the covering mass (4) contains at least one phosphor material which is suitable for absorbing a part of the radiation emitted by the semiconductor chip (1) and for emitting radiation with a changed wavelength compared the absorbed radiation.

17. Semiconductor component according to at least one of the preceding claims,
**characterized in that**
the semiconductor chip (1) comprises at least one phosphor material which is suitable for absorbing a part of the radiation emitted by the semiconductor chip (1) and for emitting radiation with a changed wavelength compared to the absorbed radiation.

18. Housing base body for at least one semiconductor chip (1), in particular for a radiation emitting semiconductor component with at least one radiation emitting semiconductor chip (1), which has a recess (2) for receiving a semiconductor chip (1), in which recess there is a chip region (21) and which is bounded laterally by an inner side (32) of a wall (31) which surrounds the chip region (21), **characterized in that** the recess (2) has a periphery (31) which is formed on the inner side (32) of the wall (31) which surrounds the chip region (21), wherein
- the inner side (32) of the wall (31) is designed in such a way that, viewed from above onto a front side of the housing base body, it has at least one partial surface (33) which, viewed from the chip region (21), lies in the shade, and **in that** it can be filled with a covering mass provided for at least partial wrapping of the semiconductor chip (1) in such a way that, starting from the partial surface (33), this covering mass extends towards the semiconductor chip (1) and covers the latter, wherein
- the at least one partial surface (33) is formed on an edge of the inner side (32) towards the front side of the housing base body (3), and the inner side (32) extends in a region between a bottom surface of the recess (2) and the partial surface (33) perpendicular to the bottom surface, **characterized in that**
at least one anchoring element (24), which projects from the partial surface (33), for the covering mass (4) is formed on the at least one partial surface (33) of the inner side (32).

19. Housing base body according to claim 18,
**characterized in that**
in the inner side (32) of the wall (31) is designed in such a way that, seen in plan view of a front side of the housing base body, it has, arranged around the chip region (21), a plurality of partial surfaces (33) which, seen from the chip region (21), lie in the shade, and **in that** it can be filled with a covering mass provided for at least partial wrapping of the semiconductor chip (1) in such a way that, starting from the partial surfaces (33), this covering mass extends towards the semiconductor chip (1) and covers the latter.

20. Housing base body according to claim 18,
**characterized in that**
the inner side (32) of the wall (31) is designed in such a way that, seen in plan view of the front side of the housing base body, it has a partial surface (33) which completely surrounds the chip region (21) in the manner of a ring and which, seen from the chip region (21), lies in the shade, and **in that** it can be filled with a covering mass which is provided for at least partial wrapping of the semiconductor chip (1) in such a way that, starting from the partial surface (33), this covering mass extends towards the semiconductor chip (1) and covers the latter.

21. Housing base body according to any of the claim 18 to 20,
**characterized in that**
the partial surface (33) extends from the front side of the housing base body in the direction of the chip region (21) in a funnel-like manner throughout.

22. Housing base body according to any of claim 18 to 20,
**characterized in that**
the at least one partial surface (33) of the inner side (32) is the front side of the housing base body (3).

23. Housing base body according to any of claim 18 to 22,
**characterized in that**
the at least one partial surface (33) of the inner side (32) is formed by means of at least one chamfer (331) at the front end of the wall (31).

24. Housing base body according to claim 18 to 22,
**characterized in that**
the at least one partial surface (33) of the inside (32) is formed at its front end by means of at least one bevel (332) of the wall (31) which is concave in cross-section.

25. Housing base body according to claim 18 to 24,
**characterized in that**
a plurality of anchoring elements (24) for the covering mass (4) are arranged on the at least one partial surface (33) of the inner side (32), in particular distributed uniformly around the recess (2).

26. Housing base according to claim 25,
**characterized in that**
the recess (2) is designed in such a way that the covering mass (4) can form a continuous sealing ring around the recess (2) on the at least one partial surface (33) of the inner side (32) outside the anchoring elements (24) when viewed from inside.

27. Housing base body according to at least one of the claims 18 to 26,
**characterized in that**
the recess (2) is designed as a reflector.

28. Housing base body according to at least one of the claims 18 to 27,
**characterized in that**
the housing base body (3) is prefabricated on a metallic lead frame (6).

## Revendications

1. Élément semi-conducteur optoélectronique doté d'au moins une puce semi-conductrice (1) émettant un rayonnement (11) et d'un corps de base de boîtier (3),
- la puce semi-conductrice (1) étant agencée dans une cavité (2) du corps de base de boîtier (3),
- la cavité (2) étant délimitée latéralement par une face intérieure (32) d'une paroi (31) entourant la puce semi-conductrice (1) et au moins partiellement remplie d'une masse d'enrobage (4) qui recouvre la puce semi-conductrice (1) et qui est bien perméable à un rayonnement électromagnétique émis par la puce semi-conductrice (1),
- la face intérieure (32) de la paroi (31) étant réalisée de telle sorte qu'elle présente, en vue du dessus sur la face avant de l'élément semi-conducteur, au moins une surface partielle (33) qui, vue de la puce semi-conductrice (1) émettant un rayonnement, est dans l'ombre et est au moins partiellement couverte de masse d'enrobage (4), et à partir de laquelle la masse d'enrobage (4) s'étend vers la puce semi-conductrice (1) et la recouvre,
- ladite au moins une surface partielle (33) étant réalisée sur un bord de la face intérieure (32) vers la face avant du corps de base de boîtier (3), et la face intérieure (32) s'étendant, dans une zone située entre une surface de plancher de la cavité (2) et la surface partielle (33), perpendiculairement à la surface de plancher,
**caractérisé en ce qu'**
- un élément d'ancrage (24), qui saille dans la masse d'enrobage (4), est réalisé sur ladite au moins une surface partielle (33) de la face intérieure (32).

2. Élément semi-conducteur selon la revendication 1,
**caractérisé en ce que**
la face intérieure (32) de la paroi (31) est réalisée de telle sorte que, vue du dessus sur la face avant de l'élément semi-conducteur, elle présente plusieurs surfaces partielles (33) agencées autour de la puce semi-conductrice qui, vues de la puce semi-conductrice (1) émettant un rayonnement, sont dans l'ombre et couvertes au moins partiellement de masse d'enrobage (4) et à partir desquelles la masse d'enrobage (4) s'étend en direction de la puce semi-conductrice (1) et la recouvre.

3. Élément semi-conducteur selon la revendication 1,
**caractérisé en ce que**
la face intérieure (32) de la paroi (31) est réalisée de telle sorte que, vue du dessus sur la face avant de l'élément semi-conducteur, elle présente une surface partielle (33) entourant entièrement, de manière circulaire, la puce semi-conductrice (1), laquelle surface partielle, vue de la puce semi-conductrice (1) émettant le rayonnement, est dans l'ombre et couverte au moins partiellement de masse d'enrobage (4) entourant entièrement la puce semi-conductrice (1).

4. Élément semi-conducteur selon l'une quelconque des revendications 1 à 3,
**caractérisé en ce qu'**
une ligne séparatrice triphasée entre air/masse d'enrobage/ corps de base de boîtier passe entièrement sur la surface partielle (33).

5. Élément semi-conducteur selon l'une quelconque des revendications 1 à 3,
**caractérisé en ce que**
ladite au moins une surface partielle (33) de la face intérieure (32) est la face avant du corps de base de boîtier (3).

6. Élément semi-conducteur selon l'une quelconque des revendications 1 à 5,
**caractérisé en ce que**
ladite au moins une surface partielle (33) de la face intérieure (32) est réalisée au moyen d'au moins un chanfrein (331) sur le bord avant de la paroi (31).

7. Élément semi-conducteur selon l'une quelconque des revendications 1 à 5,
**caractérisé en ce que**
ladite au moins une surface partielle (33) de la face intérieure (32) est réalisée au moyen d'au moins une coupure en biseau (332), de section droite concave, de la paroi (31) sur son bord avant.

8. Élément semi-conducteur selon au moins l'une quelconque des revendications précédentes,
**caractérisé en ce que**
la puce semi-conductrice (1) présente un matériau susceptible d'émettre au moins partiellement un rayonnement ultraviolet.

9. Élément semi-conducteur selon au moins l'une quelconque des revendications précédentes, **caractérisé en ce que** la masse d'enrobage (4) contient un matériau à base de silicone, notamment de la résine de silicone.

10. Élément semi-conducteur selon au moins l'une quelconque des revendications précédentes,
**caractérisé en ce que**
la masse d'enrobage (4) présente une consistance gélatineuse.

11. Élément semi-conducteur selon au moins l'une quelconque des revendications précédentes,
**caractérisé en ce que**
sont agencés répartis sur ladite au moins une surface partielle (33) de la face intérieure (32), notamment de façon régulière autour de la cavité (2), plusieurs éléments d'ancrage (24) qui saillent dans la masse d'enrobage (4) à partir de la surface partielle (33).

12. Élément semi-conducteur selon au moins l'une quelconque des revendications précédentes,
**caractérisé en ce que**
le(s) élément(s) d'ancrage est (sont) réalisé(s) en tant que saillie(s), téton(s) ou nervure(s) d'ancrage saillant vers l'extérieur de ladite au moins une surface partielle (33) de la face intérieure (32) et que la masse d'enrobage (4) enjambe le(s) élément(s) d'ancrage.

13. Élément semi-conducteur selon au moins l'une quelconque des revendications précédentes,
**caractérisé en ce que**
la masse d'enrobage (4) réalise sur ladite au moins une surface partielle (33) de la face intérieure (32) une bague d'étanchéité continue autour de la cavité (2).

14. Élément semi-conducteur selon au moins l'une quelconque des revendications précédentes,
**caractérisé en ce que**
la cavité (2) est réalisée en tant que réflecteur du rayonnement émis par la puce semi-conductrice.

15. Élément semi-conducteur selon au moins l'une quelconque des revendications précédentes,
**caractérisé en ce que**
le corps de base de boîtier (3) est préfabriqué sur un cadre conducteur (6) métallique d'un seul tenant à partir d'une pâte de moulage en matière plastique.

16. Élément semi-conducteur selon au moins l'une quelconque des revendications précédentes,
**caractérisé en ce que**
la masse d'enrobage (4) contient au moins un matériau à substance fluorescente susceptible d'absorber une partie du rayonnement émis par la puce semi-conductrice (1) et d'émettre un rayonnement à longueur d'onde modifiée par rapport au rayonnement absorbé.

17. Élément semi-conducteur selon au moins l'une quelconque des revendications précédentes,
**caractérisé en ce que**
la puce semi-conductrice (1) présente au moins un matériau à substance fluorescente susceptible d'absorber une partie du rayonnement émis par la puce semi-conductrice (1) et d'émettre un rayonnement à longueur d'onde modifiée par rapport au rayonnement absorbé.

18. Corps de base de boîtier pour au moins une puce semi-conductrice (1), notamment pour un élément semi-conducteur émettant un rayonnement et doté d'au moins une puce semi-conductrice (1) émettant un rayonnement (11), laquelle présente une cavité (2) destinée à recevoir une puce semi-conductrice (1), dans laquelle se trouve une zone à puce (21) et qui est délimitée latéralement par une face intérieure (32) d'une paroi (31) entourant la zone de puce (21),
- la face intérieure (32) de la paroi (31) étant réalisée de telle sorte qu'elle présente, vue de dessus sur la face avant du corps de base de boîtier, au moins une surface partielle (33) qui, vue de la zone de puce (21), est dans l'ombre, et qu'elle peut être remplie d'une masse d'enrobage, prévue pour enrober au moins partiellement la puce semi-conductrice (1), de telle sorte que cette masse s'étend, à partir de la surface partielle (33), jusqu'à la puce semi-conductrice (1) et la recouvre,
- ladite au moins une surface partielle (33) est réalisée sur un bord de la face intérieure (32) vers la face avant du corps de base de boîtier (3), et la face intérieure (32) s'étend, dans une zone située entre une surface au plancher de la cavité (2) et ladite surface partielle (33), à la perpendiculaire de la surface au plancher,
**caractérisé en ce que**
sur ladite au moins une surface partielle (33) de la face intérieure (32) est réalisé pour la masse d'enrobage (4) au moins un élément d'ancrage (24) saillant de la surface partielle (33).

19. Corps de base de boîtier selon la revendication 18,
**caractérisé en ce que**
la face intérieure (32) de la paroi (31) est réalisée de telle sorte qu'elle présente, vue du dessus sur une face avant du corps de base de boîtier, plusieurs surfaces partielles (33) agencées autour de la zone de puce (21), lesquelles sont, vues de la zone de puce (21), dans l'ombre, et qu'elle peut être remplie d'une masse d'enrobage prévue pour enrober au moins partiellement la puce semi-conductrice (1) de telle sorte que cette masse s'étend, à partir des surfaces partielles (33), jusqu'à la puce semi-conductrice (1) et la recouvre.

20. Corps de base de boîtier selon la revendication 18,
**caractérisé en ce que**
la face intérieure (32) de la paroi (31) est réalisée de telle sorte qu'elle présente, vue du dessus sur la face avant du corps de base de boîtier, une surface partielle (33) entourant entièrement de manière circulaire la zone de puce (21), laquelle surface partielle est, vue de la zone de puce (21), dans l'ombre, et qu'elle peut être remplie d'une masse d'enrobage prévue pour enrober au moins partiellement la puce semi-conductrice (1), de telle sorte que cette masse s'étend, à partir de la surface partielle (33) jusqu'à la puce semi-conductrice (1) et la recouvre.

21. Corps de base de boîtier selon l'une quelconque des revendications 18 à 20,
**caractérisé en ce que**
la surface partielle (33) est, sur tout le trajet allant de la face avant du corps de base de boîtier vers la zone de puce (21), en forme d'entonnoir.

22. Corps de base de boîtier selon l'une quelconque des revendications 18 à 20,
**caractérisé en ce que**
ladite au moins une surface partielle (33) de la face intérieure (32) est la face avant du corps de base de boîtier (3).

23. Corps de base de boîtier selon l'une quelconque des revendications 18 à 22,
**caractérisé en ce que**
ladite au moins une surface partielle (33) de la face intérieure (32) est réalisée au moyen d'au moins un chanfrein (331) sur l'extrémité avant de la paroi (31).

24. Corps de base de boîtier selon l'une quelconque des revendications 18 à 22,
**caractérisé en ce que**
ladite au moins une surface partielle (33) de la face intérieure (32) est réalisée au moyen d'au moins une coupure en biseau (332), de section droite concave, de la paroi (31) sur son extrémité avant.

25. Corps de base de boîtier selon la revendication 18 à 24,
**caractérisé en ce que**
plusieurs éléments d'ancrage (24) pour la masse d'enrobage (4) sont agencés répartis sur ladite au moins une surface partielle (33) de la face intérieure (32), notamment répartis de manière régulière autour de la cavité (2).

26. Corps de base de boîtier selon la revendication 25,
**caractérisé en ce que**
la cavité (2) est réalisée de telle sorte que la masse d'enrobage (4) peut réaliser, vu de l'intérieur, à l'extérieur des éléments d'ancrage (24), autour de la cavité (2) une bague d'étanchéité continue, sur ladite au moins une surface partielle (33) de la face intérieure (32).

27. Corps de base de boîtier selon au moins l'une quelconque des revendications 18 à 26,
**caractérisé en ce que**
la cavité (2) est réalisée en tant que réflecteur.

28. Corps de base de boîtier selon au moins l'une quelconque des revendications 18 à 27,
**caractérisé en ce que**
le corps de base de boîtier (3) est préfabriqué sur un cadre conducteur métallique (6).
